# EUROPEAN PATENT APPLICATION

(11) **EP 1 964 892 A2**
(43) Date of publication of application: **03.09.2008**
(21) Application number: 08102128.9
(22) Date of filing: 28.02.2008
(51) Int. Cl.: C09B 47/00, G11B 7/248

(54) **Optical layer including µ-oxo-bridged boron-subphthalocyanine dimer**

(30) Priority: 02.03.2007 JP 2007053265
(71) Applicant: ORIENT CHEMICAL INDUSTRIES, LTD., Osaka-shi, Osaka 535-0022 (JP)
(72) Inventor: Mori, Tomohiro, Osaka Osaka 572-8581 (JP); Furuya, Fumio, Osaka Osaka 572-8581 (JP); Yamasaki, Yasuhiro, Osaka Osaka 572-8581 (JP)
(74) Representative: Jönsson, Hans-Peter

(57) **Abstract**

An optical layer comprises µ-oxo-bridged boron subphthalocyanine dimer. The µ-oxo-bridged boron subphthalocyanine dimer is represented by the following chemical formula (1). 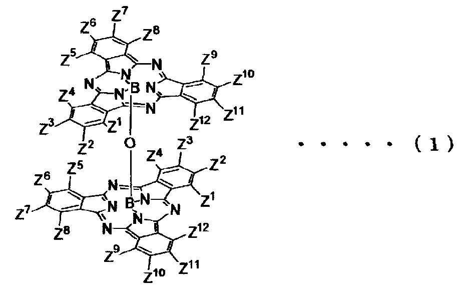 (In the chemical formula (1), Z¹ to Z¹² are the same or different to each other and selected from the groups consisting of a hydrogen atom, a hydroxyl group, a mercapto group, an alkyl group, an aralkyl group, an aryl group, an amino group, an alkoxyl group and a thioether group. Z¹ to Z¹² have one or more substitutional groups or have no substitutional group.)

## Description

The present invention relates to an optical layer that includes µ-oxo-bridged boron-subphthalocyanine dimer and is used for a functional optical thin layer.

An optical layer of a functional optical thin layer such as a light-transmissive layer of an antireflective layer, a color filter and an optical filter and so on is a material that is necessary and important for an apparatus for displaying an image such as a liquid-crystal display and a plasma display.

Among the optical layers, the antireflective layer is used for coating the surface of the display of a cellular phone or a computer, the windshield of a car and so on. The antireflective layer is used widely as a material that prevents reflection, which is caused by the sunlight or a fluorescent light, from reflecting on the surface of a display. The antireflective layer is also necessary for displaying a clear image on the display. Most of such antireflective layers can be obtained through forming inorganic compound into a film by Chemical Vapor Deposition Method (CVD Method) or Physical Vapor Deposition Method (PVD Method). An antireflective layer manufactured by forming organic compound into a film is also known. For example, Japanese Patent Provisional Publication No.8-64492 discloses an antireflective layer manufactured by using metal-free phthalocyanine.

Additionally, it is also known that subphthalocyanine monomer, which condenses fewer than phthalocyanine, is used for a functional optical thin layer, an optical element, or the raw material thereof. For example, Japanese Patent Provisional Publication No.2004-10838 discloses color resist ink and a color filter used for emitting blue color. Japanese Patent Provisional Publication No.2005-200601 discloses aqueous blue ink for full-color printing of high bright colorfulness, and Japanese Patent Provisional Publication No.2005-344021 discloses colorant that absorbs orange light used for the front panel of a plasma display. In addition, Japanese Patent Provisional Publication No.2006-13226 discloses an organic light emitting device (LED).

Application possibility of the subphthalocyanine monomer to various fields as colorant, a thin layered chemical material, an information recording material, and an emitting material has been studied.

However, the light resistance and the resolvability of the subphthalocyanine monomer are insufficient. Therefore, it is necessary to prepare a thin layer thereof by applying a colorant dispersion prepared by dispersing the subphthalocyanine monomer in a solvent. The thin layer prepared by using such colorant dispersion cannot achieve the sufficient transparency unless the thin layer is prepared by using the subphthalocyanine monomer that is pulverized homogeneously to the particle size of ultrafine particle region that is 0.5µm or less. If the subphthalocyanine monomer is pulverized to the ultrafine particle region, the surface area thereof expands. As a result, the light resistance of the subphthalocyanine monomer decreases significantly. Moreover, it is difficult to prepare a homogeneous thin layer if a colorant dispersion that is difficult to disperse homogeneously is used.

On the other hand, some functional optical thin layers have an absorption property under the specific wavelength region. Examples of the functional optical thin layer are an antireflective layer that is coated on a merchantable widescreen display such as a plasma display panel (PDP) or a liquid-crystal display; a color filter; a blue laser region compliant optical recording medium; a photo-receptor. It is required that the functional optical thin layer has small half-value width of the wavelength of 530nm to 580nm and also the sufficient absorption property thereof.

The present invention has been developed to solve the foregoing problems. It is an object of the present invention to provide an optical layer that has light resistance, absorption in the specific wavelength region and an excellent antireflection property as the said functional optical thin layer. Without damaging the property that subphthalocyanine originally has, the optical layer of the present invention is provided by using a subphthalocyanine derivative having a sufficient resolvability.

The optical layer of the present invention developed for accomplishing the foregoing objects includes the µ-oxo- bridged boron-subphthalocyanine dimer. For the reason that the optical layer includes colorant that comprises the µ-oxo- bridged boron-subphthalocyanine dimer as the principle component, the optical layer becomes useful as a functional optical thin layer.

It is preferable that the optical layer includes the µ-oxo- bridged boron-subphthalocyanine dimer represented by the following chemical formula (1). 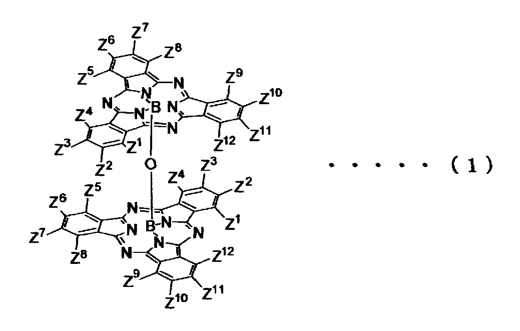 (In the chemical formula (1), Z¹ to Z¹² are the same or different to each other and selected from the group consisting of a hydrogen atom; a hydroxyl group; a mercapto group; an alkyl group having a straight-chain or a branched-chain of 1 to 20 carbon atoms that is unsubstituted, partial-fluoro-substituted or perfluoro-substituted; an aralkyl group having a straight-chain or a branched-chain of 1 to 20 carbon atoms that is unsubstituted, partial-fluoro-substituted or perfluoro-substituted; an aryl group; an amino group; an alkoxyl group; and a thioether group. Z¹ to Z¹² may have one or more substitutional groups or no substitutional group.)

It is further preferable that the optical layer includes colorant that comprises the µ-oxo- bridged boron-subphthalocyanine dimer represented by the chemical formula (1) as the principle component.

The optical layer is for example formed on a base material by a coating agent for an optical layer, for example ink, which includes colorant that comprises the µ-oxo- bridged boron-subphthalocyanine dimer as the principle component.

The optical layer has an absorption property to the light having the wavelength ranging from 500nm to 600 nm and is suitable for a functional optical thin layer such as a light-transmissive thin layer and an antireflective thin layer.

The µ-oxo-bridged boron-subphthalocyanine dimer is derived from a subphthalocyanine monomer.

A method for manufacturing the µ-oxo-bridged boron-subphthalocyanine dimer is as follows. By a step of reacting halo boron-subphthalocyanine represented by the following chemical formula (2) 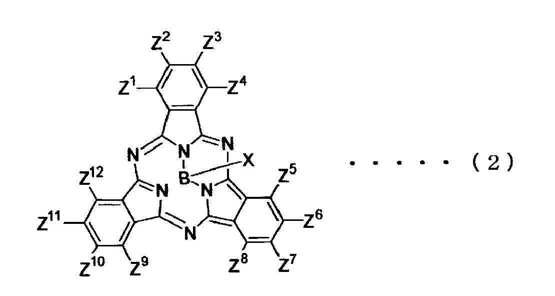 (in the chemical formula (2), Z¹ to Z¹² are the same or different to each other and selected from the group consisting of a hydrogen atom; a hydroxyl group; a mercapto group; an alkyl group having a straight-chain or a branched-chain of 1 to 20 carbon atoms that is unsubstituted, partial-fluoro-substituted or perfluoro-substituted; an aralkyl group having a straight-chain or a branched-chain of 1 to 20 carbon atoms that is unsubstituted, partial-fluoro-substituted or perfluoro-substituted; an aryl group; an amino group; an alkoxyl group; and a thioether group. Z¹ to Z¹² may have one or more substitutional groups or no substitutional group. X is a halogen atom selected from fluorine, chlorine, bromine and iodine)
with hydroxy boron-subphthalocyanine represented by the following chemical formula (3) 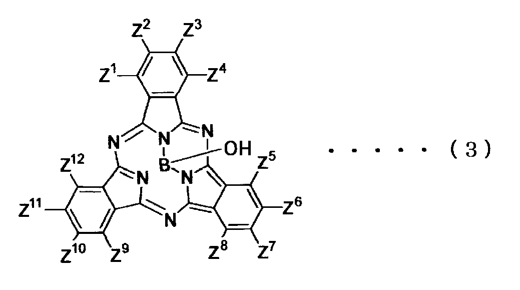 (in the chemical formula (3), Z¹ to Z¹² are the same as Z¹ to Z¹² in the chemical formula (2)),
the µ-oxo-bridged boron-subphthalocyanine dimer represented by the chemical formula (1) is manufactured.

Another method for manufacturing the µ-oxo-bridged boron-subphthalocyanine dimer is as follows. By a step of performing the dehydration reaction with the hydroxy boron-subphthalocyanine represented by the chemical formula (3), the µ-oxo-bridged boron-subphthalocyanine dimer represented by the chemical formula (1) is manufactured.

The hydroxy boron-subphthalocyanine represented by the chemical formula (3) can be obtained for example by a step in which the halo boron-subphthalocyanine represented by the chemical formula (2) is hydrolyzed.

By dimerizing the subphthalocyanine monomer, the µ-oxo-bridged boron-subphthalocyanine dimer included in the optical layer of the present invention can be mass-produced by simple procedures and with high yield. While maintaining the excellent characteristic of the subphthalocyanine monomer, the resolvability to the solvent and the light resistance of the µ-oxo- bridged boron-subphthalocyanine dimer are improved compared to the subphthalocyanine monomer.

Additionally, compared to the subphthalocyanine monomer, the µ-oxo-bridged boron-subphthalocyanine dimer can sufficiently control shift of the desired wavelength and the broadening of the half-value width that are attributed to the molecular association at the solid-state of the thin layer.

The µ-oxo-bridged boron-subphthalocyanine dimer included in the optical layer of the present invention has a property of excellently absorbing the light having the wavelength ranging from 500nm to 600nm.

A coating agent for an optical layer including colorant that comprises the µ-oxo-bridged boron-subphthalocyanine dimer as the principle component, for example ink, is not prepared by dispersing the dimer that has high resolvability and high light resistance but by dissolving the dimer. Therefore, the coating agent can form an optical layer having homogeneous thickness. Moreover, the light transmissivity under the specific wavelength and the absorbance coefficient of the absorption range of the visible region in the specific wavelength of the optical layer are improved, and the half-value width thereof is apparently narrow. Therefore, as a functional optical thin layer such as a light-transmissive thin layer and an antireflective thin layer, the optical layer has an excellent property of blocking the only specific wavelength.

As a result, a display and the like coated by the optical layer can display an image with high bright contrast ratio.

As an antireflective thin layer or a light-transmissive thin layer, the optical layer effectively blocks the light having the wavelength of 550nm that is the center of the visible region. And the optical layer hardly disturbs the transmission of a red light near the said wavelength. Therefore, it is highly useful for improving the visibility performance of a display.

Fig. 1 shows absorbing spectra of µ-oxo-bridged boron-subphthalocyanine dimer (compounds 1, 2, 3 and 4) included in an optical layer to which the present invention is applied and a compound (intermediate compound A-1) included in an optical layer to which the present invention is not applied.

Fig. 2 shows transmission spectra of an optical layer including a µ-oxo-bridged boron-subphthalocyanine dimer (compounds 1, 2, 3 and 4) to which the present invention is applied and an optical layer including a compound (intermediate compound A-1) to which the present invention is not applied.

Fig. 3 shows transmission spectra of a saturated condition of a compound (intermediate compound A-1) included in an optical layer to which the present invention is not applied and a thin layer of a dispersing element.

Hereunder, embodiments of the present invention are explained in detail. The present invention is not intended to be limited.

The optical layer of the present invention includes the µ-oxo-bridged boron-subphthalocyanine dimer represented by the chemical formula (1). The optical layer is a functional optical thin layer that is capable of blocking the light having the specific wavelength or transmitting only the light having the specific wavelength, due to the characteristics of absorbing light and interfering or scattering reflected light. As an antireflective thin layer or a light-transmissive thin layer such as a color filter or an optical filter, an optical layer is used for coating an information recording apparatus such as a liquid-crystal display and a plasma display.

The µ-oxo-bridged boron-subphthalocyanine dimer is for example represented by the following chemical formula (4). 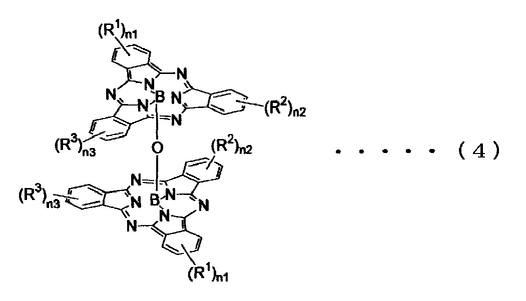 (In the chemical formula (4), R¹ to R³ are the same or different to each other and selected from the group consisting of a hydrogen atom; a hydroxyl group; a mercapto group; an alkyl group having a straight-chain or a branched-chain of 1 to 20 carbon atoms that is unsubstituted, partial-fluoro-substituted or perfluoro-substituted; an aralkyl group having a straight-chain or a branched-chain of 1 to 20 carbon atoms that is unsubstituted, partial-fluoro-substituted or perfluoro-substituted; an aryl group; an amino group; an alkoxyl group; and a thioether group. R¹ to R³ may have substitutional groups or no substitutional group. n1 to n3 are the same or different to each other and are integral numbers of 1 to 4.)

In the chemical formula (4), examples of the unsubstituted alkyl group are methyl group, ethyl group, n-propyl group, i-propyl group, n-butyl group, i-butyl group, sec-butyl group, t-butyl group, n-pentyl group, neo-pentyl group, n-hexyl group, n-heptyl group, n-octyl group, 2-ethylhexyl group, n-decyl group, lauryl group, stearyl group and so on.

Examples of the partial-fluoro-substituted alkyl group are 2,2,2-trifluoroethyl group, 3,3,3-trifluoropropyl group, 2,2,3,3,3,-pentafluoropropyl group, 4,4,4,-trifluorobuty group and so on. Examples of the perfluoro-substituted alkyl group are perfluoromethyl group, perfluoroethyl group, perfluoro-n-propyl group, perfluoro-i-propyl group, perfluoro-n-butyl group, perfluoro-i-butyl group, perfluoro-sec-butyl group, perfluoro-n-pentyl group, perfluoro-neo-pentyl group, perfluoro-n-hexyl group, perfluoro-n-heptyl group, perfluoro-n-octyl group, perfluoro-n-decyl group and so on.

Examples of the unsubstituted aralkyl group are benzyl group, a,a-dimethylbenzyl group and so on.

Examples of the partial-fluoro-substituted aralkyl group are -CF₂C₆H₅ group, -C(CF₃)₂C₆H₅ group and so on. Examples of the perfluoro-substituted aralkyl group are -CF₂C₆F₅ group and -C(CF₃)₂C₆F₅ group.

Example of the aryl group are phenyl group, naphthyl group and so on.

Examples of the amino group are amino group; a monoalkylamino group such as methylamino group, ethylamino group, n-propylamino group, i-propylamino group, n-butylamino group, sec-butylamino group, t-butylamino group, n-pentylamino group, neo-pentylamino group, n-hexylamino group, n-heptylamino group, n-octylamino group and so on; a dialkylamino group such as dimethylamino group, diethylamino group, di-n-propylamino group, di-i-propylamino group, di-n-butylamino group, di-sec-butylamino group, di-t-butylamino group, di-n-pentylamino group, di-neo-pentylamino group, di-n-hexylamino group, di-n-heptylamino group, di-n-octylamino group and so on.

Examples of the alkoxyl group are methoxy group, ethoxy group, n-propoxy group, i-propoxy group, n-butoxy group, i-butoxy group, sec-butoxy group, t-butoxy group, n-pentyloxy group, neo-pentyloxy group, n-hexyloxy group, n-heptyloxy group, n-octyloxy group and so on.

Examples of the thioether group are methylthio group, ethylthio group, n-propylthio group, i-propylthio group, n-butylthio group, i-butylthio group, sec-butylthio group, t-butylthio group, n-pentylthio group, neo-pentylthio group, n-hexylthio group, n-heptylthio group, n-octylthio group and so on.

The said groups are allowed to have one or more substitutional groups. Examples of the substitutional groups are a halogen group such as F, Cl, Br, I and so on; nitro group; cyano group; hydroxyl group; mercapto group; an alkyl group such as methyl group, ethyl group, propyl group, butyl group, pentyl group, hexyl group, 2-ethylhexyl group, n-octyl group and so on; an alkoxyl group such as methoxy group, ethoxy group, propoxy group, butoxy group, pentyloxy group, hexyloxy group, 2-ethylhexyloxy group, n-octyloxy group and so on; an aryl group such as phenyl group, naphthyl group, phenethyl group and so on; an aralkyl group such as benzyl group, a,a-dimethylbenzyl group and so on; amino group; an alkylamino group; a dialkylamino group and so on.

The µ-oxo-bridged boron-subphthalocyanine dimer is manufactured as follows.

The µ-oxo-bridged boron-subphthalocyanine dimer can be manufactured by dimerizing subphthalocyanine monomer, for example. By using this step, the µ-oxo-bridged boron-subphthalocyanine dimer can be simply obtained with high yield.

The µ-oxo-bridged boron-subphthalocyanine dimer has sufficient resolvability into a solution and excellent light resistance. Therefore, it can be applied to various fields such as an ink and a functional optical thin layer.

An example of detailed manufacturing method of the µ-oxo-bridged boron-subphthalocyanine dimer is as follows.

Subphthalocyanine can be obtained by a conventional method. For example, a subphthalocyanine is synthesized from phthalonitrile derivative by the procedure disclosed in Japanese Patent Provisional Publication No.2005-289854 or a similar procedure. The chemical reaction formula is represented by the following formula (5). 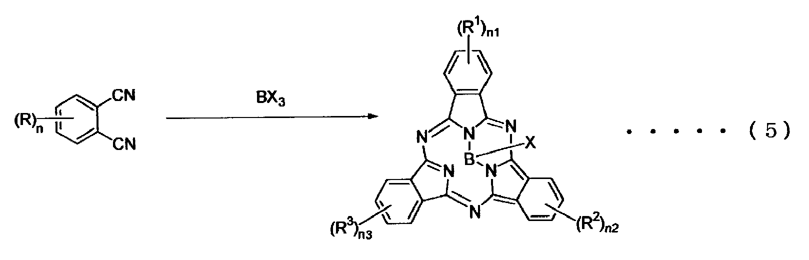 (In the formula (5), R¹ to R³ and n1 to n3 are the same as the before-mentioned. X is a halogen atom selected from fluorine, chlorine, bromine and iodine.)

In the chemical formula (5), R and n on the phthalonitrile derivative is appropriately selected according to the substitutional groups on the subphthalocyanine R¹ to R³ and n1 to n3.

Boron compound BX₃ has a halogen atom selected from fluorine, chlorine, bromine and iodine as X and also boron trichloride having chlorine atom as X. The boron trichloride is gas at room temperature and under normal pressure; therefore, it can be bubbled into the reaction mixture. Solution including the boron trichloride can be added dropwise to the reaction mixture. The liquefied boron trichloride under cooling by an appropriate cooling procedure also can be added dropwisw into the reaction mixture.

As a solvent used for the synthesis reaction of the subphthalocyanine, it is not intended to be limited as long as the solvent has a high boiling point, dissolves the phthalonitrile derivative excellently and does not react with the boron halogenide. Examples of the solvent are monochlorobenzene, dichlorobenzene, trichlorobenzene, naphthalene, monomethylnaphthalene, monochloronaphthalene, dichloronaphthalene, quinoline, isoquinoline, sulfolane and so on. These can be used solely or prulary by mixing two or more thereof.

As represented by the following chemical reaction formula (6) 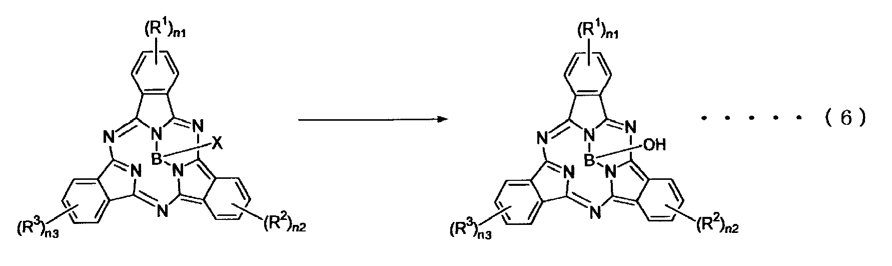 (in the chemical formula (6), R¹ to R³, n1 to n3 and X are the same as the before-mentioned),
the obtained halo boron-subphthalocyanine is derived to the hydroxy boron-subphthalocyanine by being hydrolyzed. The reaction of hydrolysis can be proceeded under either an acidic condition or a basic condition.

Examples of acid that can be used for the hydrolysis under the acidic condition are an inorganic acid such as sulfuric acid, hydrochloric acid, nitric acid and so on, preferably sulfuric acid. These can be used by being diluted to an appropriate concentration by water. Additionally, according to the resolvability of the halo boron-subphthalocyanine, an organic solvent can be added in order to proceed the reaction.

Examples of base that can be used for the hydrolysis under the basic condition are a hydroxide of alkali metal and alkali earth metal that are illustrated by lithium hydroxide, sodium hydroxide, potassium hydroxide, calcium hydroxide and so on; carbonate, hydrogen carbonate and so on that are illustrated by lithium carbonate, sodium carbonate, potassium carbonate, cesium carbonate, calcium carbonate, sodium hydrogen carbonate, potassium hydrogen carbonate and so on, preferably sodium hydroxide. These can be added to the reaction mixture as solid or as solution prepared by dissolving these with water or appropriate organic solvent. Additionally, the reaction can be proceeded by adding the organic solvent according to the resolvability of the halo boron-subphthalocyanine.

Detailed example of the reaction of the hydrolysis is as follows. The solvent, the acid or the base is put into a reaction vessel. Then, the halo boron-subphthalocyanine is added therein at the temperature of -10 degrees centigrade to 10 degrees centigrade, and the mixture is stirred for 1 to 2 hours at the same temperature. Then, the reaction temperature is raised to 10 degrees centigrade to 50 degrees centigrade, and the mixture is reacted for 1 to 6 hours.

After the reaction, if necessary the mixture is dispersed in a medium in which the hydroxy boron-subphthalocyanine of intermediate is insoluble, for example water and alcohol, and then the mixture is filtered in order to eliminate the medium. Additionally, if necessary the obtained hydroxy boron-subphthalocyanine is washed with a medium for purification.

When the obtained hydroxy boron-subphthalocyanine is washed with the medium for purification, the medium is not intended to be limited as long as it dissolves byproducts while it does not dissolve the hydroxy boron-subphthalocyanine of the intermediate. Examples of the medium are water, methanol, ethanol, n-propanol, i-propanol, n-butanol, acetone, hexane, ethyl acetate, diethyl ether, tetrahydrofuran (THF) and so on. These can be used solely or plurally by mixing two or more thereof.

The obtained hydroxy boron-subphthalocyanine is heated and reacted to be proceeded by the dehydration-condensation. As a result, as represented by the following chemical formula (7) 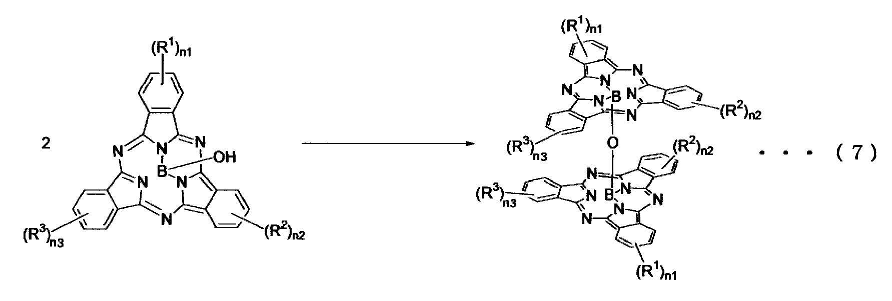 (in the chemical formula (7), R¹ to R³ and n1 to n3 are the same as the before-mentioned),
the hydroxy boron-subphthalocyanine is dimerized and thus derived to the µ-oxo-bridged boron-subphthalocyanine dimer.

Concretely, the dimerization reaction by the dehydration-condensation is as follows. The hydroxy boron-subphthalocyanine is dissolved or suspended in a solvent or suspended and if necessary heated under the presence of an appropriate dehydrating agent in order for the dehydration-condensation in. Then, the µ-oxo-bridged boron-subphthalocyanine dimer is synthesized.

The solvent that can be used for the dimerization reaction by the dehydration-condensation is not intended to be limited as long as the solvent dissolves or suspends the hydroxy boron-subphthalocyanine. Examples thereof are an alkylbenzene such as benzene, toluene, xylene, mesitylene, ethylbenzene, n-propylbenzene, cumene and so on; a halogenated benzene such as monochlorobenzene, dichlorobenzene, bromobenzene, dibromobenzene and so on; a solvent including nitrogen such as N,N-dimethylformamide, N, N-dimethylacetamide, N-methylpyrolidone, 1,3-dimethyl-2-imidazolidinone, 1,3-dimethylpropylenurea and so on; an ether such as tetrahydrofuran, diphenyl ether, anisole, 1,4-dioxane, monoglime, diglime, triglime and so on; a ketone such as acetone, methyl ethyl ketone, methyl isobutyl ketone, cyclohexanon and so on.

For the dimerization reaction by the dehydration-condensation, an appropriate dehydrating agent can be used. The dehydrating agent is not intended to be limited as long as it does not have influence on groups on aromatic ring of the hydroxy boron-subphthalocyanine. Examples thereof are a hydride of alkali metal and alkali earth metal such as lithium hydride, sodium hydride, potassium hydride, calcium hydride and so on; a hydrosulfate group of alkali metal and alkali earth metal such as magnesium sulfate, sodium sulfate and so on; an organic dehydrating agent such as DCC (dicyclohexylcarbodiimide); molecular sieves and so on.

It is preferable that the reaction temperature of the dimerization reaction by the dehydration-condensation is at reflux temperature of the said solvent, and the reaction time thereof is 1 to 24 hours.

After the dimerization reaction by the dehydration-condensation, it is preferable that the reaction mixture is filtered to obtain the µ-oxo-bridged boron-subphthalocyanine dimer. The mixture can be additionally purified according to the purpose. For example, the µ-oxo-bridged boron-subphthalocyanine dimer can be obtained by using a refining means such as column chromatography and the like. Incidentally, the refining means is not intended to be limited.

The method for obtaining the µ-oxo-bridged boron-subphthalocyanine dimer through the dimerization reaction by the dehydration-condensation was explained above. Next, another method for obtaining the µ-oxo-bridged boron-subphthalocyanine dimer is explained.

The halo boron-subphthalocyanine represented by the before-mentioned chemical reaction formula (5) and the hydroxy boron- subphthalocyanine represented by the before-mentioned chemical reaction formula (6) are reacted as shown in the following chemical reaction formula (8). 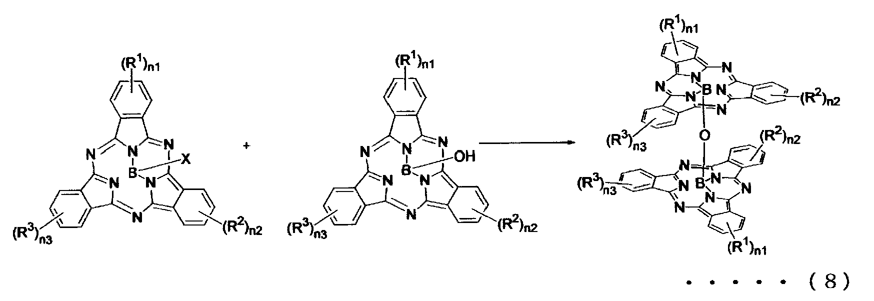 (In the chemical formula (8), R¹ to R³, n1 to n3, and X are the same as the above-mentioned.) The µ-oxo-bridged boron-subphthalocyanine dimer can be obtained by the dimerization reaction of condensation by the dehydrohalogenation.

Concretely, the dimerization reaction of condensation by the dehydrohalogenation is as follows. As shown in the above-mentioned chemical reaction forumula (8), the halo boron-subphthalocyanine and the hydroxy boron- subphthalocyanine are dissolved or suspended and if necessary heated under the presence of an appropriate base and condensed by the dehydrohalogenation, in order to synthesize the µ-oxo-bridged boron-subphthalocyanine dimer.

As a solvent that can be used for the dimerization reaction of condensation by the dehydrohalogenation, it is not intended to be limited as long as it can dissolve or suspend the halo boron-subphthalocyanine and the hydroxy boron-subphthalocyanine. Examples thereof are an alkylbenzene such as benzene, toluene, xylene, mesitylene, ethylbenzene, n-propylbenzene, cumene and so on; a halogenated benzene such as monochlorobenzene, dichlorobenzene, bromobenzene, dibromobenzene and so on; a solvent including nitrogen such as N,N-dimethylformamide, N, N-dimethylacetamide, N-methylpyrolidone, 1,3-dimethyl-2-imidazolidinone, 1,3-dimethylpropylenurea and so on; an ether such as tetrahydrofuran, diphenyl ether, anisole, 1,4-dioxane, monoglyme, diglyme, triglyme and so on; a ketone such as acetone, methyl ethyl ketone, methyl isobutyl ketone, cyclohexanon and so on.

An appropriate base can be used for the dimerization reaction of condensation by the dehydrohalogenation in order to eliminate the by-produced hydrogen halogenide and therefore accelerate the reaction. As the base, it is not intended to be limited as long as it does not have influence on groups on aromatic ring of the hydroxy boron-subphthalocyanine and the halo boron-subphthalocyanine. Examples thereof are a hydride of alkali metal and alkali earth metal such as lithium hydride, sodium hydride, potassium hydride, calcium hydride and so on; a hydroxide of alkali metal and alkali earth metal such as lithium hydroxide, sodium hydroxide, potassium hydroxide, calcium hydroxide and so on; a carbonate and hydrogen carbonate such as lithium carbonate, sodium carbonate, potassium carbonate, cesium carbonate, calcium carbonate, sodium hydrogen carbonate, potassium hydrogen carbonate and so on.

It is preferable that the reaction temperature of the dimerization reaction condensation by the dehydrohalogenation is at reflux temperature of the said solvent, and the reaction time thereof is 1 to 24 hours.

After the dimerization reaction by condensation by the dehydrohalogenation, it is preferable that the reaction mixture is filtered to obtain the µ-oxo-bridged boron-subphthalocyanine dimer. The mixture can be purified according to the purpose. For example, a product material can be obtained by using a refining means such as column chromatography and the like or recrystallization. Incidentally, the refining means is not intended to be limited.

Detailed examples of the halo boron-subphthalocyanine are explained as follows. Incidentally, the halo boron-subphthalocyanine is not intended to be limited. 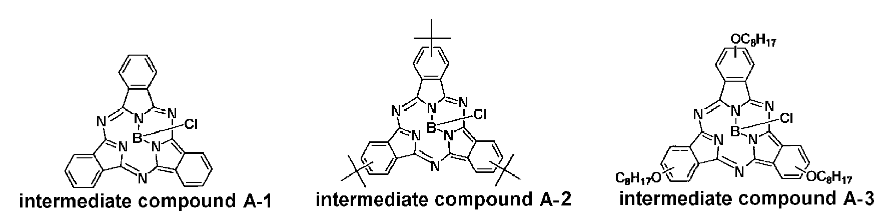 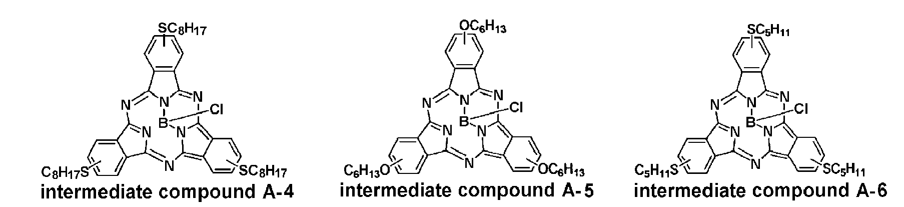 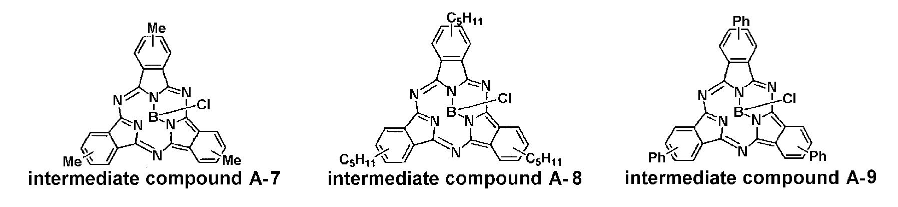 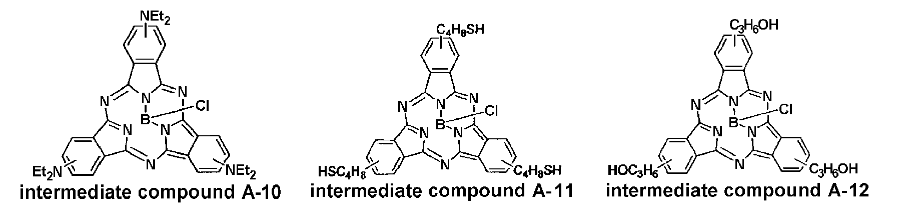 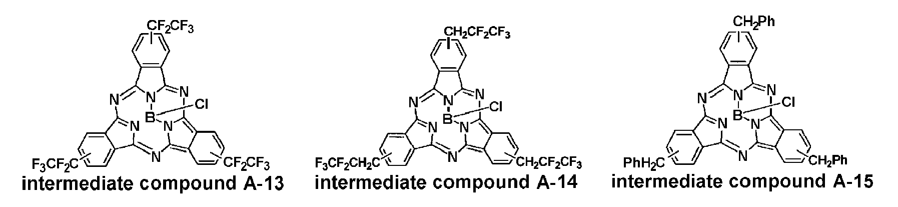 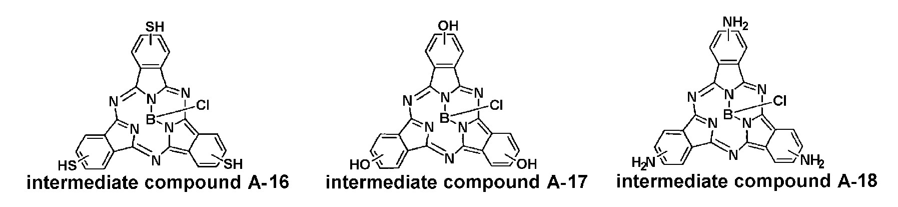 Hereunder, detailed examples of the hydroxy boron-subphthalocyanine are explained as follows. Incidentally, the hydroxy boron-subphthalocyanine is not intended to be limited. 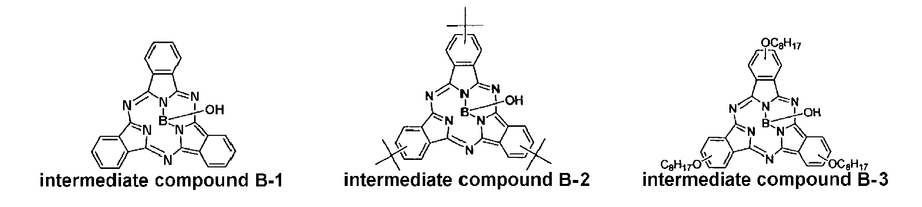 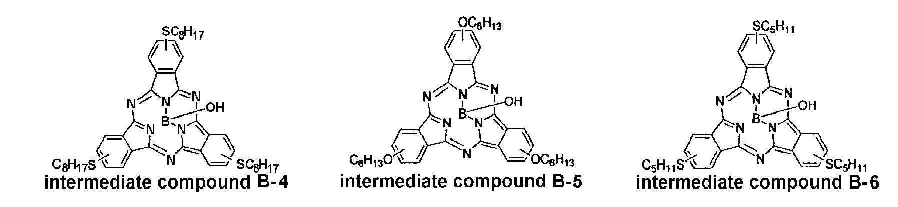 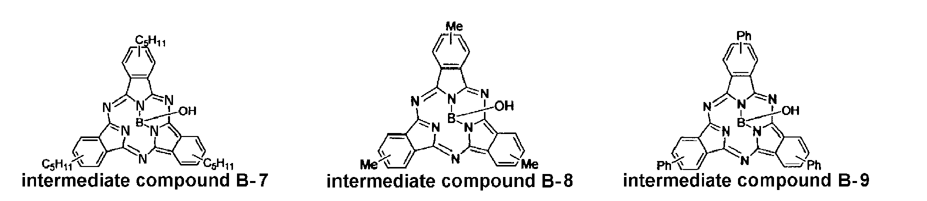 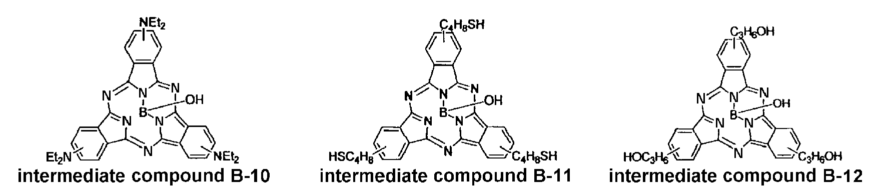 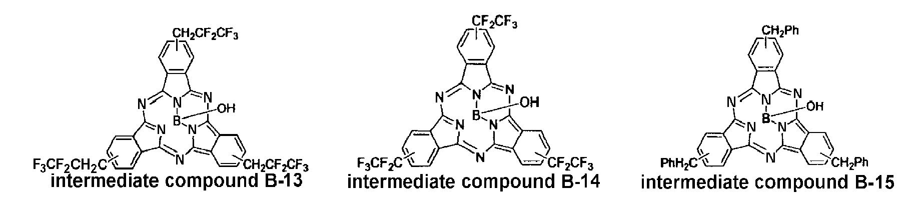 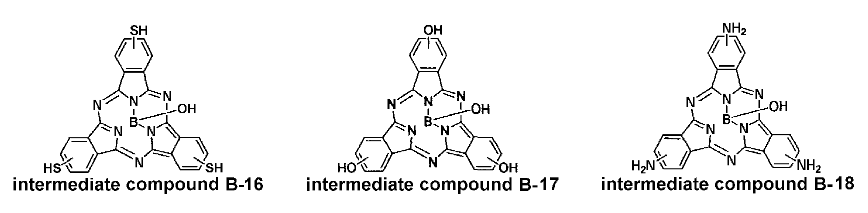 Hereunder, detailed examples of the boron-subphthalocyanine dimer of the present invention are explained as follows. Incidentally, the boron-subphthalocyanine dimer is not intended to be limited.

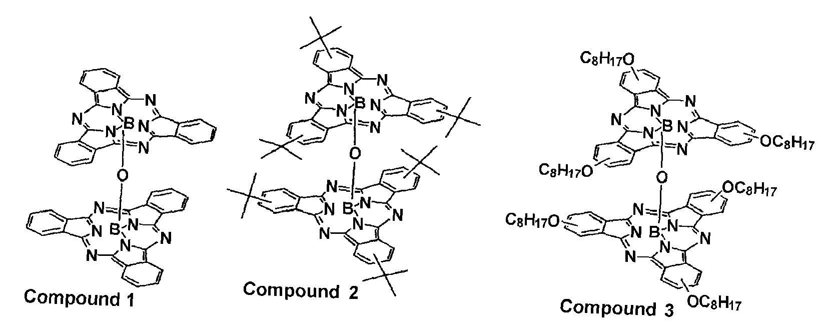

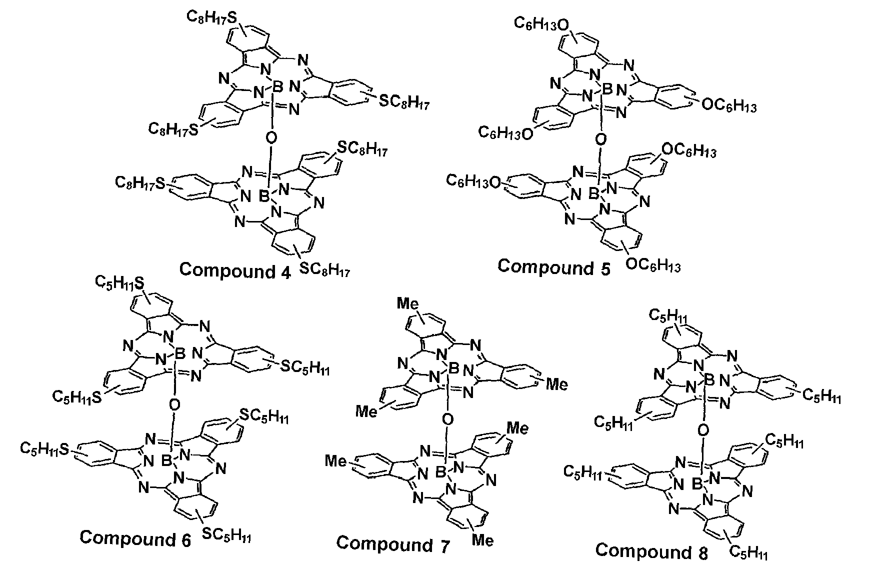

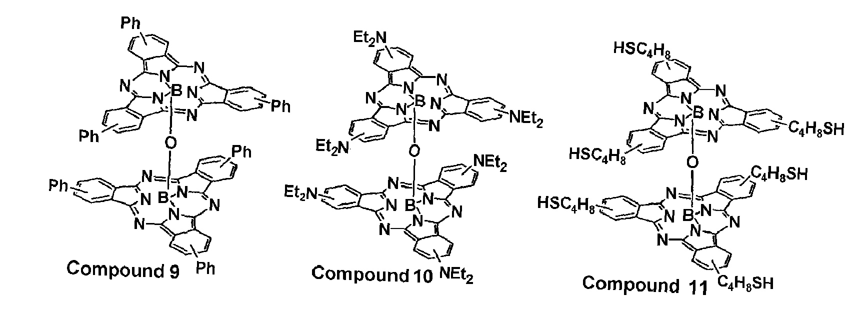

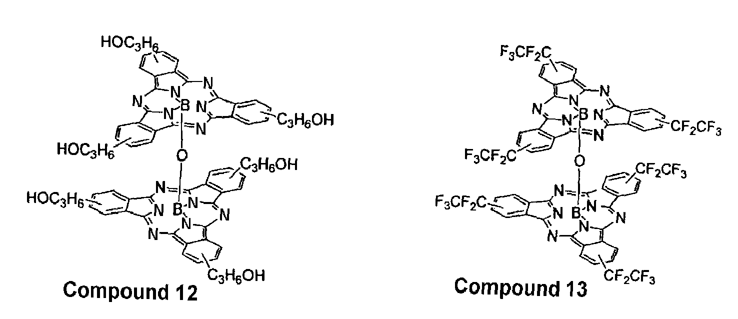

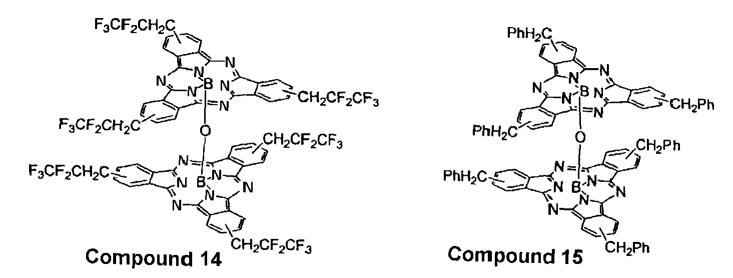

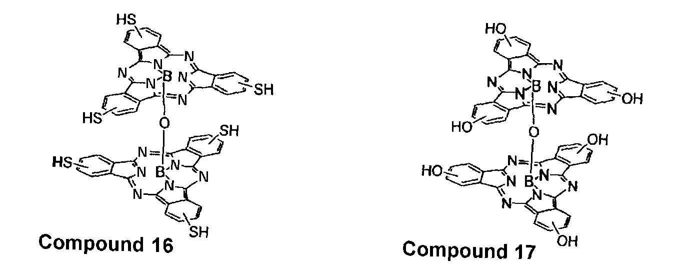

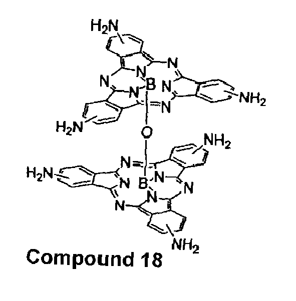

Hereunder, the optical layer of the present invention is explained in detail.

Firstly, the optical layer of the present invention such as a functional optical thin layer including the µ-oxo-bridged boron-subphthalocyanine dimer is explained.

The optical layer is for example a functional optical thin layer of a light-transmissive thin layer. The light-transmissive thin layer is a thin layer that is capable of absorbing and blocking the light having the specific wavelength due to colorant, and obtaining the light having the desired wavelength.

The light-transmissive thin layer includes the µ-oxo-bridged boron-subphthalocyanine dimer. The µ-oxo-bridged boron-subphthalocyanine dimer has a narrow half-value width and control the broadening of the wavelength attributed to the molecular association at the solid-state. As a result, the light-transmissive thin layer is capable of blocking only the light having the wavelength near 550nm.

The light having the wavelength near 550nm corresponds to the green color light that is the center of the visible region. Therefore, a human views the light having the wavelength near 550m significantly. Because the light-transmissive thin layer includes the µ-oxo-bridged boron-subphthalocyanine dimer of the colorant which absorbs the green color light having the wavelength near 550nm, the light-transmissive thin layer improves the contrast of a display, and as a result the display can display a clear image thereon.

A film-forming method of the light-transmissive thin layer is as follows. The colorant whose principle component is the µ-oxo-bridged boron-subphthalocyanine dimer dissolved into an appropriate medium to prepare a coating agent such as ink, is applied on a base material to adhere thereon. The amount of the µ-oxo-bridged boron-subphthalocyanine dimer included in the coating agent for the total amount of the coating agent is preferably 0.001 weight% to 20 weight%. It is preferable that the amount thereof is 0.05 weight% to 5 weight%, further preferably 0.1 weight% to 3 weight%.

The molar absorbance coefficient of the colorant used for the light-transmissive thin layer is preferably from 40000dm³mol⁻¹cm⁻¹ to 150000 dm³mol⁻¹cm⁻¹, further preferably from 60000dm³mol⁻¹cm⁻¹ to 110000 dm³mol⁻¹cm⁻¹.

Another optical layer of the present invention is explained. The optical layer can be a functional optical thin layer such as an antireflective thin layer. The antireflective thin layer prevents reflection of a fluorescent light or a background from reflecting on the surface of a display. The antireflective thin layer improves the visibility performance of a display.

The antireflective thin layer includes the µ-oxo-bridged boron-subphthalocyanine dimer as a light absorbent. The µ-oxo-bridged boron-subphthalocyanine dimer absorbs the green color light having the wavelength near 550nm that is the center of the visible region, and as a result the display can display a clear image thereon. Also, because the half-value width of the µ-oxo-bridged boron-subphthalocyanine dimer is narrow, it does not cause a decrease of a chromatic purity of the red light neighboring the wavelength of the green color light. Therefore, the display can display a clear image thereon.

In addition, the functional optical thin layer such as the light-transmissive thin layer and the antireflective thin layer can be formed into a layer by mixing other functional materials as long as the optical property of the µ-oxo-bridged boron-subphthalocyanine dimer is not disturbed. Examples of other functional materials are near-infrared absorbing colorant, ultraviolet absorbing colorant, colorant for adjusting color hue and so on.

The near-infrared absorbent is used for preventing infections by the near-infrared ray such as the noise coming from a speaker that is caused due to the interference of the near-infrared ray with a mechanical error of home electric appliances and a receiving part of a microphone. The near-infrared absorbent is also used for preventing a mechanical error of an automatic door. It is preferable that the near-infrared absorbent is an agent that transmits the light having the wavelength of a visible region and absorbs only near-infrared ray having the wavelength of 900nm to 1200nm. Organic colorant is likely used for the absorbent.

The examples of the organic colorant are dithiol metal complex, cyanine type compound, diimmonium type compound, phthalocyanine type compound, naphthalocyanine type compound and so on. The organic colorant can be used solely or plural by mixing two or more thereof. A method for adding the organic colorant is not intended to be limited, but it can be added to a coating agent such as an ink for a functional optical thin layer while it can be also formed into a layer by a colander method, a coating method, a casting method and so on.

Although either inorganic or organic ultraviolet absorbent agent can be used, it is more practical to use an organic ultraviolet absorbent. As an organic ultraviolet absorbent, it is preferable that the organic ultraviolet absorbent has the maximum absorption near the wavelength between 300nm to 400nm, preferably near the wavelength of 350nm, and absorbs 80% or more of the light within the range. Examples thereof are benzotriazole type compound, benzophenone type compound, ester salicylate type compound, acrylate type compound, oxalic acid anilide type compound, hindered amine type compound and so on. These can be used solely or pluraly, but it is preferable that these are used pluraly by mixing two or more thereof. Incidentally, a method for adding the organic colorant is not intended to be limited, but it can be added to a coating agent such as an ink for a functional optical layer while it can be also formed into a layer by a colander method, a coating method, a casting method and so on.

Colorant for adjusting color hue is used for controlling the color balance of a displayed color and also improving the contrast of a display. Examples thereof are cyanine (polymethine)-type colorant, quinine-type colorant, azo-type colorant, indigo-type colorant, polyene-type colorant, spiro-type colorant, porphyrin-type colorant, phthalocyanine-type colorant, naphthalocyanine-type colorant and so on. These can be used solely or prulaly, but it is preferable that these are used pluraly by mixing two or more thereof.

Examples of a method for forming a optical thin layer of the functional optical thin layers are an ink jet recording method, a physical vapor deposition (PVD method), a chemical vapor deposition (CVD method), a colander method, a coating method, a casting method and so on. Among the PVD methods, especially a vacuum evaporation method is used. The vacuum evaporation method is proceeded as follows, for example. Organic colorant or metal oxide is heated under vacuum condition, and then it is applied to a base material such as a material between two electrode layers in order to form a thin layer.

The µ-oxo-bridged boron-subphthalocyanine dimer can be used for such the vacuum evaporation method to form a thin layer.

Also, the coating agent including the µ-oxo-bridged boron-subphthalocyanine dimer can be applied to a material as a film state by a spin coat method. The µ-oxo-bridged boron-subphthalocyanine dimer has high resolvability to various solvents and high light resistance. Therefore, the coating agent is substantial.

Because the µ-oxo-bridged boron-subphthalocyanine dimer can be used as a dye and has high light resistance, the coating agent including the µ-oxo-bridged boron-subphthalocyanine dimer is preferable as an ink for forming a light absorbing layer on a display material such as a display and the like. By forming a light absorbing layer on a display material for example a display using the coating agent, a light absorbing layer can block unnecessary light and perform antireflection property and so on.

Examples of a liquid medium used for the coating agent are a keton-type solvent such as acetone, methyl ethyl ketone, cyclohexanon, 4-methoxy-4-methylpentanone and so on; a hydrocarbon-type solvent such as cyclohexane, methylcyclohexane, n-pentane, n-hexane, n-heptane and so on; an alcohol-type solvent such as methanol, ethanol, propanol, isopropanol and so on; a glycol and ether-type solvent thereof illustrated by polyol such as ethylene glycol, diethylene glycol, propylene glycol, glycerin, dipropylene glycol, 1,2-hexanediol, 2,4,6-hexanetriol and so on, dioxane, methyl cellosolve, ethyl cellosolve, butyl cellosolve, diethylen glycol monobutyl ether, ethylene glycol monobutyl ether, ethylene glycol monoethyl ether and so on; an ester-type solvent such as ethyl acetate, butyl acetate, n-propyl acetate and so on; a halogen-type solvent such as 1,2-dichloroethane, dichloromethane, 1,1,2-trichloroethane, chloroform and so on; an aromatic-type solvent such as toluene, xylene and so on; dimethylsulfoxide; N-methyl-2-pyrolidone and 2-pyrolidone; y-butyllactone; THF and so on. The liquid medium can be used solely or prulary by mixing and also with a small quantity of water.

Among the above-mentioned liquid medium, it is preferable that the liquid medium is selected from keton-type solvent such as acetone, methyl ethyl ketone, cyclohexanon and so on; the alcohol-type solvent such as methanol, ethanol, isopropanol and so on; the aromatic-type solvent such as toluene, xylene and so on; the ester-type solvent such as ethyl acetate, butyl acetate, n-propyl acetate and so on; N-methyl-2-pyrolidone; dimethylsulfoxide; ethylene glycol and so on.

The coating agent is allowed to include further various additives. Examples of the additive are for example a binder (resin), penetrating agent, antifoaming agent, pigment, antioxidant, ultraviolet absorbent, a lubricant agent, a preservative agent, fungicide, a rust-preventing agent, dispersant, a rheology control agent, a surface-active agent, pH adjuster, film modifier, a charge control agent (a charge controlling agent), fat element of animal oil and plant oil, and the like. The additive is selected accordingly and can be used solely or prulaly by mixing several thereof.

The element of the above-mentioned binder (resin) is used for fixing the µ-oxo-bridged boron-subphthalocyanine dimer fixedly, stabilizing an ink, adjusting a viscosity and so on. Common resin can be used accordingly as long as it dissolves to the above-mentioned liquid medium.

Examples of the binder (resin) element are polyvinyl-type resin such as polyvinyl alcohol, polyvinyl butyral, polyvinylpyrrolidone, vinyl pyrrolidone-vinyl acetate copolymer and so on; polyamine-type resin such as polyalyllamine, polyvinylamine, polyethylenimine and so on; polyacrylate-type resin such as polymethyl acrylate, polyethylene acrylate, polymethyl methacrylate, polyvinyl methacrylate and so on; rosin and modified rosin with resin (phenol, maleic acid, fumaric acid and so on); cellulose-type resin such as ethylcellulose, nitrocellulose and so on; polyolefin resin such as polyethylene resin, polypropylene resin and so on; xylene resin modified with phenol; xylene resin; terpene phenol resin; phenol resin; ketone resin; acrylate resin; styrene-acrylate resin; styrene-maleic acid resin; terpene-type resin; terpene-maleic acid resin; polystyrene resin; polyurethane resin; acrylurethane resin; polyester resin; vinyl chloride resin; vinylidene chloride resin; polyvinyl formal resin and copolymer thereof; alkyd resin; epoxy resin; polyesterimide resin; polyamide resin; polyamideimide resin; silicone resin; fluorinated resin (fluorinated polymer); natural resin (e.x. gum arabic and gelatin) and so on. The resin can be used solely or prulaly by mixing two or more thereof.

The coating agent can be prepared by the procedures of mixing the above-mentioned µ-oxo-bridged boron-subphthalocyanine dimer, the liquid medium and if necessary the binder, the additives and so on, dissolving thereof by stirring and if necessary diluting or adding other additives. Mixing and diluting can be proceeded by a general stirring using a stirrer with paddles, a high-speed dispersion machine, emulsion machine and so on.

If necessary, the obtained coating agent can be purified by being filtered before or after the dilution. If filtering the coating agent, it is performed for example by a filter having a diameter of mesh of 3.0µm or less, preferably 1.0um or less.

The coating agent is used for example as an ink in order to form a functional optical thin layer such as a light-transmissve thin layer or an antireflective thin layer.

### (Example)

Hereunder, the optical layer of the present invention is explained in detail referring to examples. Incidentally, SubPcB hereunder represents the boron-subphthalocyanine.

### (Manufacturing Example 1)

76.8g of phthalonitrile, 260g of p-xylene, and 270g of 1.0M boron trichloride of p-xylene solution were stirred for 1 hour at reflux temperature under nitrogen gas stream, and 29.3g of SubPcBCl [Intermediate Compound A-1] was obtained.

20.0g of the obtained [Intermediate Compound A-1] was poured into 600mL of concentrated sulfuric acid of 5 degrees centigrade or less by cooling in order to maintain the temperature thereof at 5 degrees centigrade or less. Then it was stirred for 5 hours at 5 degrees centigrade or less. The solution was poured into 3 liters of iced water in order to slurry and then filtered. It was dispersed in 3 liters of water, stirred for 1 hour under reflux condition and filtered. Then, 12.6g of SubPcBOH [Intermediate Compound B-1] was obtained.

13.4g of the obtained [Intermediate Compound B-1] was poured into 500ml of ortho-dichlorobenzene, and the solution was stirred for 22 hours under reflux condition. After the reaction, by the procedures of filtering the solution, concentrating the filtrate and washing the residue with 400ml of dimethylformamide, 4.5g (34.3% of yield from the Intermediate Compound B-1)of (SubPcB)₂O [Compound 1] was obtained.

The evaluation of elementary analysis of (SubPcB) ₂O [Compound 1] is shown in Table 1.

**Table 1**

| Evaluation of Elementary Analysis of Compound 1 (C₄₈H₂₄N₁₂B₂O) | | | |
|---|---|---|---|
| | C | H | N |
| Calculated Value (%) | 71.49 | 3.00 | 20.84 |
| Analytical Value (%) | 69.37 | 3.08 | 19.95 |

The measurement results of ¹H-NMR and ¹³C-NMR thereof are shown.
NMR(300MHz)
¹H-NMR(CDCl₃):δ7.77(dd,J=3,6Hz,6H), 8.61(dd,J=3,6Hz,6H)ppm
¹³C-NMR(CDCl₃): δ122.0, 129.5, 130.5, 150.4ppm

The yield and the maximum absorption wavelength in chloroform as well as the molar absorbance coefficient are shown in Table 5. Incidentally, a spectral photometer of UV-1700 available from Shimadzu Corporation was used. Additionally, the evaluated solubility is shown in Table 6. The evaluation supports that the (SubPcB)₂O[Compound 1] has the structure of the before-mentioned chemical formula.

### (Manufacturing Example 2)

25.0g of 4-t-butylphthalonitrile, 58.9g of p-xylene and 61.3g of 1.0M boron trichloride of p-xylene solution were stirred for 2 hours at reflux temperature under nitrogen gas stream, and 7.6g of †-Bu₃SubPcBCl [Intermediate Compound A-2] was obtained.

3.0g of the obtained [Intermediate Compound A-2] was poured into 50ml of dimethylformamide and 50ml of 1N sodium hydrate aqueous solution of 5 degrees centigrade or less. The solution was stirred for 1 hour at 5 degrees centigrade and then for 18 hours at room temperature. By filtering slurry and washing the slurry with 100ml of 25% of methanol aqueous solution and then with 100ml of water, 2.6g of †-Bu₃SubPcBOH [Intermediate Compound B-2] was obtained.

2.0g of [Intermediate Compound A-2], 2.0g of [Intermediate Compound B-2] and 1.0g of sodium hydride were added to 60ml of xylene, and the solution was stirred for 1 hour at reflux temperature. By the procedures of filtering the reaction solution, concentrating the filtrate and purifying the residue by a silica-gel column chromatography (chloroform: hexane=1:1), 0.65g (33.6% of yield from the Intermediate Compound B-2) of (t-Bu₃SubPcB)₂O [Compound 2] was obtained.

The evaluation of elementary analysis of (t-Bu₃subPcB)₂O [Compound 2] is shown in Table 2.

**Table 2**

| Evaluation of Elementary Analysis of Compound 2 (C₇₂H₇₂N₁₂B₂O) | | | |
|---|---|---|---|
| | C | H | N |
| Calculated Value (%) | 75.66 | 6.35 | 14.70 |
| Analytical Value (%) | 74.88 | 6.62 | 12.58 |

The measurement results of ¹H-NMR and ¹³C-NMR thereof are shown.
NMR(300MHz)
¹H-NMR(CDCl₃): δ1.49(m,54H), 7.80(m,6H), 8.48(m,6H), 8.65(m,6H)ppm
¹³C-NMR(CDCl₃): δ30-35, 55-60, 120-150ppm

The yield and the maximum absorption wavelength in chloroform as well as the molar absorbance coefficient are shown in Table 5. Additionally, the evaluated solubility is shown in Table 6. The evaluation supports that the (†-Bu₃SubPCB)₂O [Compound 2] has the structure of the before-mentioned chemical formula.

### (Manufacturing Example 3)

10.0g of 4-octyloxyphthalonitrile, 16.9g of p-xylene and 17.6g of 1.0M boron trichloride of p-xylene solution were stirred for 2 hours at reflux temperature under nitrogen gas stream, and 4.0g of (C₈H₁₇O)₃SubPcBCl [Intermediate Compound A-3] was obtained.

4.0g of the obtained [Intermediate Compound A-3] was poured into 20ml of dimethylformamide and 20ml of 1N sodium hydrate aqueous solution of 5 degrees centigrade or less. The solution was stirred for 1 hour at 5 degrees centigrade and then for 2 hours at room temperature. By filtering slurry and washing the slurry with 200ml of 50% of methanol aqueous solution, 3.2g of (C₈H₁₇O)₃SubPcBOH [Intermediate Compound B-3] was obtained.

By using the same method as Manufacturing Example 2, 1.07g (36.5% of yield from the Intermediate Compound B-3) of {(C₈H₁₇O)₃SubPcB}₂0 [Compound 3] was obtained from 3.0g of [Intermediate Compound A-3] and 3.0g of [Intermediate Compound B-3].

The evaluation of elementary analysis of {(C₈H₁₇O)₃SubPcB}₂O [Compound 3] is shown in Table 3.

**Table 3**

| Evaluation of Elementary Analysis of Compound 3 (C₉₆H₁₂₀N₁₂B₂O₇) | | | |
|---|---|---|---|
| | C | H | N |
| Calculated Value (%) | 73.18 | 7.68 | 10.67 |
| Analytical Value (%) | 72.53 | 7.62 | 9.98 |

The measurement results of ¹H-NMR and ¹³C-NMR thereof are shown.
NMR(300MHz)
¹H-NMR(CDCl₃):δ0.89(m,18H), 1.30(m,48H), 0.82(m,12H), 2.20(m,12H), 4.06(m,12H), 7.09(m,6H), 7.29(m,6H), 7.75(m,6H)ppm
¹³C-NMR(CDCl₃): δ15-65, 120-150ppm

The yield and the maximum absorption wavelength in chloroform as well as the molar absorbance coefficient are shown in Table 5. Additionally, the evaluated solubility is shown in Table 6. The evaluation supports that the {(C₈H₁₇O)₃SubPCB}₂O [Compound 3] has the structure of the before-mentioned chemical formula.

### (Manufacturing Example 4)

15.0g of 4-octylthiophthalonitrile, 24.2g of p-xylene and 25.2g of 1.0M boron trichloride of p-xylene solution were stirred for 2 hours at reflux temperature under nitrogen gas stream, and 10.5g of (C₈H₁₇S)₃SubPCBCl [Intermediate Compound A-4] was obtained.

6.0g of the obtained [Intermediate Compound A-4] was poured into 60mL of dimethylformamide and 60mL of 1N sodium hydrate aqueous solution of 5 degrees centigrade or less. The solution was stirred for 1 hour at 5 degrees centigrade and then for 2 hours at room temperature. By filtering slurry and washing the slurry with 1 liter of 50% of methanol aqueous solution and then with 3 liters of water, 4.9g of (C₈H₁₇S)₃SubPcBOH [Intermediate Compound B-4] was obtained.

5.0g of [Intermediate Compound A-4], 5.0g of [Intermediate Compound B-4] and 5.0g of sodium hydride were added to 100mL of 1,4-dioxane, and the solution was stirred for 1 hour at reflux temperature. By the procedures of filtering the reaction solution, concentrating the filtrate and purifying the residue by a silica-gel column chromatography (chloroform: hexane=1:1 / methylene chloride: ethyl acetate=100:1), 2.35g (24.0% of yield from the Intermediate Compound B-4) of {(C₈H₁₇S)₃SubPcB}₂O [Compound 4] was obtained.

The evaluation of an elementary analysis of {(C₈H₁₇S)₃SubPcB}₂O [Compound 4] is shown in Table 4.

**Table 4**

| Evaluation of Elementary Analysis of Compound 4 (C₉₆H₁₂₀N₁₂B₂OS₆) | | | | |
|---|---|---|---|---|
| | C | H | N | S |
| Calculated Value (%) | 68.96 | 7.23 | 10.05 | 11.51 |
| Analytical Value (%) | 66.77 | 7.08 | 9.99 | 10.37 |

The measurement results of ¹H-NMR and ¹³C-NMR thereof are shown.
NMR(300MHz)
¹H-NMR(CDCl₃):δ0.87(m,18H), 1.28(m,48H), 1.79(m,12H), 2.05(m,12H), 3.21(m,12H), 7.70(m,6H), 8.64(m,12H)ppm
¹³C-NMR(CDCl₃): δ14-60, 120-150ppm

The yield and the maximum absorption wavelength in chloroform as well as the molar absorbance coefficient are shown in Table 5. Additionally, the evaluated solubility is shown in Table 6. The evaluation supports that the ((C₈H₁₇S)₃SubPcB}₂O [Compound 4] has the structure of the before-mentioned chemical formula.

**Table 5**

| Manufacturing Example | Compound | Yield (%) | Top: maximum absorption wavelength(nm) Bottom: molar absorption coefficient (dm³mol⁻¹cm⁻¹) |
|---|---|---|---|
| Manufacturing Example 1 | Compound 1 | 34.3 | 532 106000 |
| | Intermediate Compound A-1 | - | 565 51000 |
| | Intermediate Compound B-1 | - | 562 45000 |
| Manufacturing Example 2 | Compound 2 | 33.6 | 543 61000 |
| | Intermediate Compound A-2 | - | 570 57000 |
| | Intermediate Compound B-2 | - | 568 57000 |
| Manufacturing Example 3 | Compound 3 | 36.5 | 543 87000 |
| | Intermediate Compound A-3 | - | 577 35000 |
| | Intermediate Compound B-3 | - | 572 30000 |
| Manufacturing Example 4 | Compound 4 | 24.0 | 553 91000 |
| | Intermediate Compound A-4 | - | 587 44000 |
| | Intermediate Compound B-4 | - | 582 54000 |

**Table 6**

| Example | Compound | Solubility (g/L) [solvent: methyl ethyl ketone] |
|---|---|---|
| Manufacturing Example 1 | Compound 1 | 1.14 |
| | Intermediate Compound A-1 | 0.025 |
| Manufacturing Example 2 | Compound 2 | 58.5 |
| Manufacturing Example 3 | Compound 3 | 83.2 |
| Manufacturing Example 4 | Compound 4 | 91.6 |

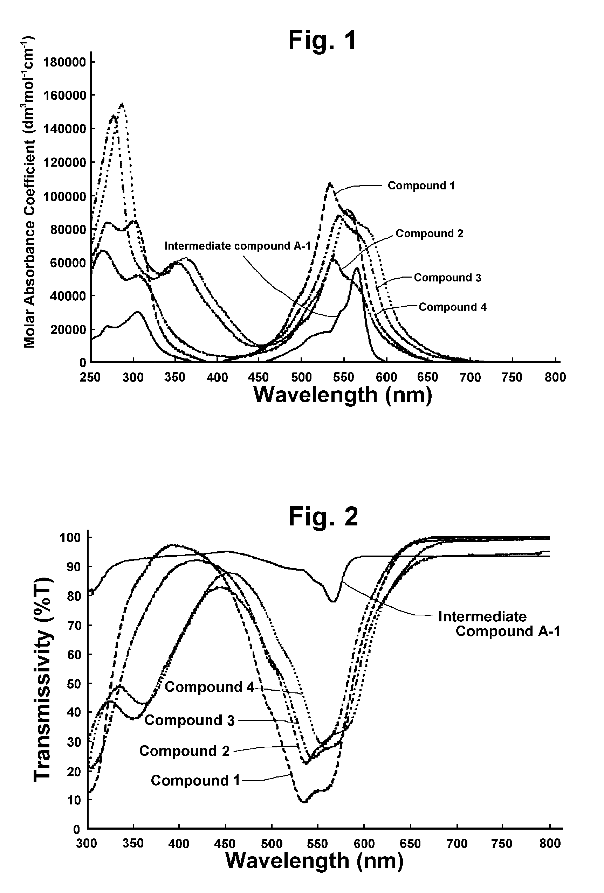

Regarding the Intermediate Compound A-1, Compound 1, 2, 3 and 4 in Table 5, the absorbing spectrums thereof in the chloroform are shown in Fig. 1. As shown in Table 5 and Table 6, the resolvability to the solvent of the subphthalocyanine dimer improved and also the molar absorbance coefficient thereof was larger compared to those of the subphthalocyanine monomer having the same substitutional groups as the subphthalocyanine dimer. Therefore, it is possible to give the subphthalocyanine dimer an absorption band in the absorption wavelength region of 550nm that is required for an antireflective layer.

Next, a forming method of a thin layer using the µ-oxo-bridged boron-subphthalocyanine dimer and an evaluation method are explained.

### (Example 1)

A functional optical thin layer of the optical layer that includes Compound 1 of the colorant for a thin layer obtained in the Manufacturing Example 1 was manufactured by the following procedures.

0.1 parts by weight of the Compound obtained in the Manufacturing Example 1 and 15 parts by weigh of polymethacrylate were mixed and dissolved into 50 parts by weight of methyl ethyl ketone and 35 parts by weight of cyclohexanone by stirring, and liquid coating agent was prepared.

The obtained coating agent was applied to a glass plate having the thickness of 1mm by using a spin coater of 1H-D7 available from Mikasa Co., Ltd, and a functional optical thin layer of the present invention was prepared.

### (Example 2)

In Example 2, a functional optical thin layer was prepared by the same procedures as Example 1 except for using a coating agent prepared by using Compound 2 obtained in Manufacturing Example 2 instead of using Compound 1 used in Example 1.

### (Example 3)

In Example 3, a functional optical thin layer was prepared by the same procedures as Example 1 except for using a coating agent prepared by using Compound 3 obtained in Manufacturing Example 3 instead of using Compound 1 used in Example 1.

### (Example 4)

In Example 4, a functional optical thin layer was prepared by the same procedures as Example 1 except for using a coating agent prepared by using Compound 4 obtained in Manufacturing Example 4 instead of using Compound 1 used in Example 1.

### (Comparative Example 1)

0.1 parts by weight of Intermediate Compound A-1 obtained in Manufacturing Example 1 and 15 parts by weight of plymethacrylate were dispersed and mixed into 50 parts by weight of methyl ethyl ketone and 35 parts by weight of cyclohexanone by stirring, and a coating agent was prepared.

The obtained coating agent was applied to a glass plate having the thickness of 1mm by using a spin coater of 1H-D7 available from Mikasa Co., Ltd, and a functional optical thin layer was prepared.

### (Comparative Example 2)

In Comparative Example 2, a thin layer was prepared by the same procedures as Example 1 except for using a coating agent prepared by using Intermediate Compound A-1 obtained in Manufacturing Example 1 instead of using Compound 1 used in Example 1. Incidentally, the additive amount of colorant to prepare a coating agent was changed to 0.5 parts by weight.

On this occasion, Intermediate Compound A-1 did not dissolve completely. Therefore, a coating agent was obtained as dispersion.

### (Comparative Example 3)

In Comparative Example 3, a coating agent was prepared and filtered as same as Comparative Example 1. Using the filtrate thereof (saturated solution of Intermediate Compound A-1), a thin layer was prepared.

### (Measurement method of transmission spectrum)

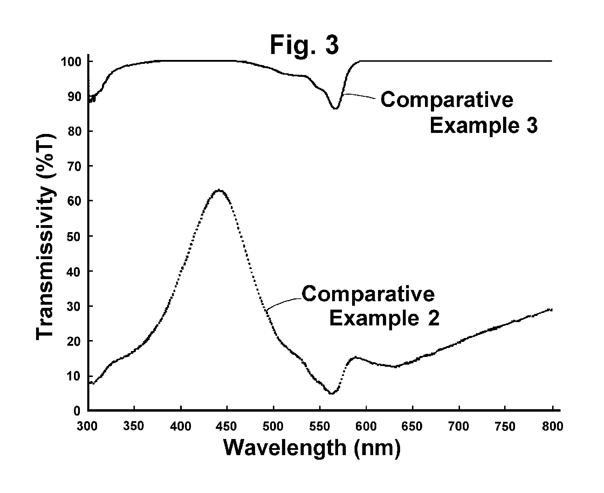

The thin layers including the subphthalocyanine obtained in Examples 1 to 4 and Comparative Examples 1 to 3 were used for the measurement. The transmissivity of the thin layer was measured by a spectral photometer of UV-1700 available from Shimadzu Corporation. The transmissivity of the thin layer in the maximum absorption is shown in Table 7. The transmission spectra of Examples 1 to 4 and Comparative Examples 1 were shown in Fig.2, and the transmission spectra of Comparative Examples 2 and 3 were shown in Fig. 3.

The transmissivity was evaluated as follows. When the transmissivity was less than 10%T, it was indicated as A. When the transmissivity was more than 10%T and less than 30%T, it was indicated as B. When the transmissivity was more than 30%T and less than 40%T, it was indicated as C. When the transmissivity was more than 40%, it was indicated as D.

### (Evaluation of haze)

The thin layers including the subphthalocyanine obtained in Examples 1 to 4 and Comparative Example 1 were used for the measurement. The haze of the thin layer was measured by a hazemeter of NDH2000 available from Nippon Denshoku Industries Co., Ltd. The measured haze value was shown in Table 8.

The haze value was evaluated as follows. When the haze value was less than 1.0, it was indicated as A. When the haze value was more than 1.0 and less than 1.5, it was indicated as B. When the haze value was more than 1.5 and less than 2.0, it was indicated as C. When the haze value was more than2.0, it was indicated as D.

### (Measurement method of light resistance)

The thin layers including the subphthalocyanine obtained in Examples 1 to 4 and Comparative Example 1 were used for the measurement. The light resistance of the thin layer was measured by a Xenon Fade-O-meter of Ci-4000 available from Atlas Corporation. The testing condition was as follows. The BST temperature was 45 degrees centigrade, the humidity was 50%, and the radiative rate was 25W/m². The coloration state after 1 hour was determined by visual observation. The obtained light resistance was shown in Table 9.

The light resistance was evaluated as follows. When the colorant was remained, it was indicated as B. When the colorant was slightly remained, it was indicated as C. When no colorant was remained, it was indicated as D.

### (Measurement method of reflectance)

The thin layers including the subphthalocyanine obtained in Examples 1 to 4 and Comparative Example 1 were used for the measurement. Incidentally, a spectral photometer of U-3410 available from HITACHI was used. A glass material was used as a base. The reflectance of the colorant thereof to the maximum absorption wavelength was measured by the spectral photometer to which an accessory device of 600 integrating sphere was put. The obtained reflectance was shown in Table 10.

The reflectance was evaluated as follows. When the reflectance was less than 5.0 %, it was indicated as A. When the reflectance was more than 5.0% and less than 10%, it was indicated as B. When the reflectance was more than 10% and less than 20%, it was indicated as C. When the reflectance was more than 20%, it was indicated as D.

**Table 7**

| Example Nos. | Transmissivity(%T) | Evaluation |
|---|---|---|
| Example 1 | 9.1 | A |
| Example 2 | 23 | B |
| Example 3 | 24 | B |
| Example 4 | 29 | B |
| Comparative Example 1 | 78 | D |

**Table 8**

| Example Nos. | Haze (%) | Evaluation |
|---|---|---|
| Example 1 | 0.60 | A |
| Example 2 | 0.81 | A |
| Example 3 | 0.82 | A |
| Example 4 | 0.81 | A |
| Comparative Example 1 | 3.99 | D |

**Table 9**

| Example Nos. | Light resistance |
|---|---|
| Example 1 | B |
| Example 2 | C |
| Example 3 | C |
| Example 4 | C |
| Comparative Example 1 | D |

**Table 10**

| Example Nos. | Reflectance (%) | Evaluation |
|---|---|---|
| Example 1 | 4.5 | A |
| Example 2 | 7.2 | B |
| Example 3 | 8.9 | B |
| Example 4 | 9.2 | B |
| Comparative Example 1 | 52.3 | D |

Regarding the performance of an optical filter, the thin layers obtained in Example 1 to 4 and the thin layer obtained in Comparative Example 1 were compared. The thin layers of Example 1 to 4 had low transmissivity to the maximum wavelength and therefore the results were good to excellent. Additionally, the thin layers of Examples 1 to 4 had less change of the desired wavelength by molecular association, broadening of half-value width, and absorptivity in the desired wavelength compared to Comparative Examples of Fig. 1 and 2.

Regarding the haze value, the haze of the thin layer of Comparative Example 1 was more than 1 due to the coating agent thereof that is a dispersant. However, the haze values of the thin layers of Example 1 to 4 were less than 1. Therefore, they were considered to be excellent results.

Regarding the light resistance, the light resistance of the thin layer of Example 1 is more excellent than that of Comparative Example 1. The light resistance of the thin layers of Examples 2, 3 and 4 were considered to be better results.

In addition, the transmission spectrum of the thin layers obtained in Comparative Examples 2 and 3 were shown in Fig. 3. As shown in Fig. 3, the thin layer of Comparative Example 2 prepared by using the coating agent of high concentrated dispersing element had low transmissivity not only to the desired wavelength, and the thin layer of Comparative Example 3 prepared by using the coating agent of saturated solution had high transmissivity to the desired wavelength.

Regarding the reflectance, the thin layers of Examples 1 to 4, especially the one of Example 1, showed the excellent reflectance property while the thin layer of Comparative Example 1 did not show enough reflectance property.

The optical layer including the µ-oxo-bridged boron-subphthalocyanine dimer of the present invention is used as a functional optical thin layer. The optical layer effectively blocks the light having the wavelength of 550nm that is the center of the visible region and is highly useful for improving the visibility performance of a display. Also, because the half value thereof is apparently narrow, the thin layer hardly prevents the red light having the neighbouring wavelength of the visible region from transmitting. Therefore, it is applicable for various functional optical thin layers. Additionally, because the µ-oxo-bridged boron-subphthalocyanine dimer has high resolvability to solvent and high light resistance, a substantial coating agent such as ink can be provided by including the µ-oxo-bridged boron-subphthalocyanine dimer thereto.

## Claims

1. An optical layer comprising µ-oxo-bridged boron-subphthalocyanine dimer.

2. The optical layer according to claim 1, wherein the µ-oxo-bridged boron-subphthalocyanine dimer is represented by the following chemical formula (1). 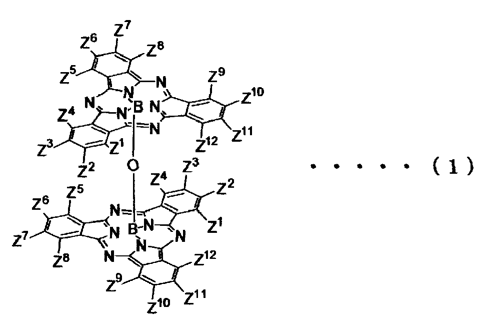 (In the chemical formula (1), Z¹ to Z¹² are the same or different to each other and selected from the group consisting of a hydrogen atom; a hydroxyl group; a mercapto group; an alkyl group having a straight-chain or a branched-chain of 1 to 20 carbon atoms that is unsubstituted, partial-fluoro-substituted or perfluoro-substituted; an aralkyl group having a straight-chain or a branched-chain of 1 to 20 carbon atoms that is unsubstituted, partial-fluoro-substituted or perfluoro-substituted; an aryl group; an amino group; an alkoxyl group; a thioether group, and Z¹ to Z¹² have one or more substitutional groups or have no substitutional group.)

3. The optical layer according to Claim 1, wherein the optical layer is an antireflective layer.

4. The optical layer according to Claim 1, wherein the optical layer is a light-transmissive layer.

5. The optical layer according to Claim 2, wherein the optical layer is formed on a base material by a coating agent including colorant that comprises the µ-oxo-bridged boron-subphthalocyanine dimer represented by the chemical formula (1) as the principle component.

6. The optical layer according to Claim 1, wherein the optical layer has an absorption property of light having the wavelength ranging from 500nm to 600nm.

7. A coating agent for an optical layer comprising a solvent and colorant that comprises the µ-oxo-bridged boron subphthalocyanine dimer as the dominant component.

8. The coating agent for an optical layer according to Claim 7, wherein the µ-oxo-bridged boron-subphthalocyanine dimer is represented by the following chemical formula (1). 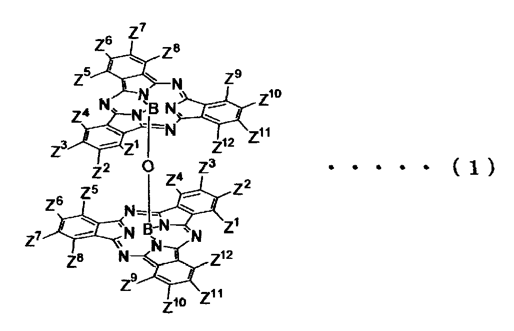 (In the chemical formula (1), Z¹ to Z¹² are the same or different to each other and selected from the group consisting of a hydrogen atom; a hydroxyl group; a mercapto group; an alkyl group having a straight-chain or a branched-chain of 1 to 20 carbon atoms that is unsubstituted, partial-fluoro-substituted or perfluoro-substituted; an aralkyl group having a straight-chain or a branched-chain of 1 to 20 carbon atoms that is unsubstituted, partial-fluoro-substituted or perfluoro-substituted; an aryl group; an amino group; an alkoxyl group; a thioether group, and Z¹ to Z¹² have one or more substitutional groups or have no substitutional group.)

9. A method for manufacturing the µ-oxo-bridged boron subphthalocyanine dimer comprising;
a step that halo boron-subphthalocyanine represented by the following chemical formula (2) 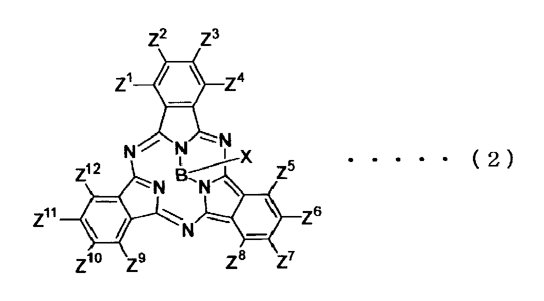 (in the chemical formula (2), Z¹ to Z¹² are the same or different to each other and selected from the group consisting of a hydrogen atom; a hydroxyl group; a mercapto group; an alkyl group having a straight-chain or a branched-chain of 1 to 20 carbon atoms that is unsubstituted, partial-fluoro-substituted or perfluoro-substituted;
an aralkyl group having a straight-chain or a branched-chain of 1 to 20 carbon atoms that is unsubstituted, partial-fluoro-substituted or perfluoro-substituted; an aryl group; an amino group; an alkoxyl group; a thioether group,
Z¹ to Z¹² have one or more substitutional groups or have no substitutional group,
X is a halogen atom selected from fluorine, chlorine, bromine and iodine)
is reacted with hydroxy boron-subphthalocyanine represented by the following chemical formula (3) 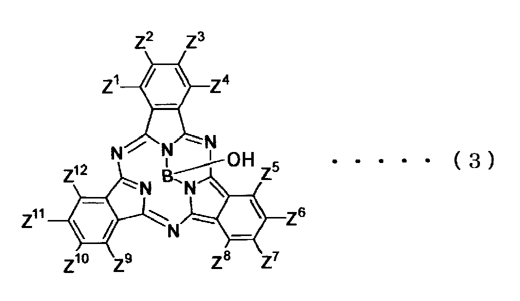 (in the chemical formula (3), Z¹ to Z¹² is the same as Z¹ to Z¹² in the chemical formula (2)),
or a step that hydroxy boron-subphthalocyanine represented by the chemical formula (3) is dehydrated,
wherein the µ-oxo-bridged boron subphthalocyanine dimer is represented by the following chemical formula (1). 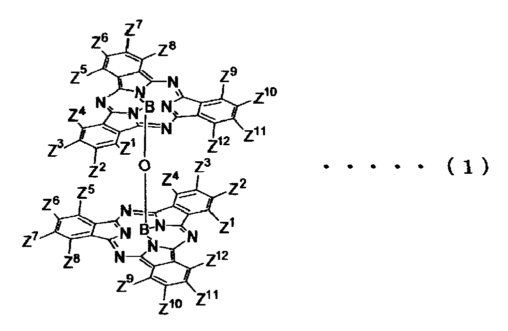 (In the chemical formula (1), Z¹ to Z¹² are the same above.)

10. The method for manufacturing the µ-oxo-bridged boron subphthalocyanine dimer according to claim 9 comprising;
a step that the hydroxy boron-subphthalocyanine represented by the chemical formula (3) is manufactured by hydrolyzing the halo boron-subphthalocyanine represented by the following chemical formula (2). 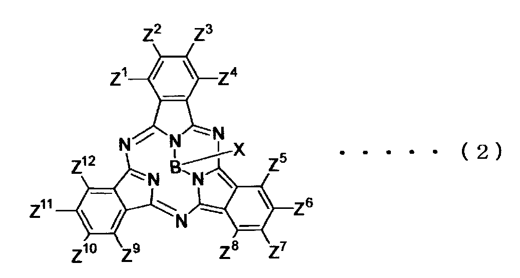 (In the chemical formula (2), Z¹ to Z¹² are the same as the above, X is a halogen atom selected from fluorine, chlorine, bromine and iodine.)
